# EUROPEAN PATENT APPLICATION

(11) **EP 4 231 031 A1**
(43) Date of publication of application: **23.08.2023**
(21) Application number: 22315037.6
(22) Date of filing: 22.02.2022
(51) Int. Cl.: G01R 33/09, G01R 33/00

(54) **MAGNETORESISTIVE ELEMENT HAVING THERMALLY ROBUST PERFORMANCES AFTER HIGH-FIELD EXPOSURE AND SENSOR COMPRISING THE MAGNETORESISTIVE ELEMENT**

(71) Applicant: Crocus Technology S.A., 38025 Grenoble (FR)
(72) Inventor: Dounia, Salim, 3800 Grenoble (FR); Cuchet, Léa, 38430 Moirans (FR); Strelkov, Nikita, 38240 Meylan (FR); Ducruet, Clarisse, 73000 Chambéry (FR); Timopheev, Andrey, 38450 Vif (FR); Childress, Jeffrey, San Jose, CA 95123 (US)
(74) Representative: P&TS SA (AG, Ltd.)

(57) **Abstract**

Magnetoresistive element (2) comprising a reference layer (23) having a fixed reference magnetization (230); a ferromagnetic sense layer (21) having a free sense magnetization (210) having a stable vortex configuration that is orientable relative to the fixed reference magnetization (230) in the presence of an external magnetic field (60); and a tunnel barrier layer (22) between the reference layer (23) and the sense layer (21) and contacting a first side (211) of the sense layer (21). The magnetoresistive element (2) further comprises a hard magnetic layer (25) arranged on a second side (212) of the sense layer (21) opposed to the first side (211), the hard magnetic layer (25) being configured to generate an interfacial magnetic coupling between the hard magnetic layer (25) and the sense layer (21) on the second side (212), such as to prevent chirality switching of the sense magnetization (210) after the magnetoresistive element (2) has been submitted to a heat treatment and an external magnetic field above vortex expulsion field.

## Description

### Technical domain

The present disclosure concerns a magnetoresistive element adapted to sense an external magnetic field and having a wide linear response and a nominal performance that remains substantially unchanged after the magnetoresistive element has been subjected to high magnetic fields. The present disclosure further concerns a magnetic sensor comprising a plurality of the magnetoresistive element.

### Related art

A magnetoresistive sensor element, based on tunnel magnetoresistance (TMR) typically comprises a pinned ferromagnetic reference layer having a fixed (pinned) reference magnetization, a ferromagnetic sense layer having a free sense magnetization (that can be oriented in a magnetic field, relative to the fixed reference magnetization), and a tunnel barrier layer between the reference and sense ferromagnetic layers. The external magnetic field can thus be sensed by measuring a resistance of the magnetoresistive sensor element. The resistance depends on the orientation and magnitude of the averaged sense magnetization relative to the reference magnetization. The sense magnetization can comprise a vortex configuration whereby the magnetization curls in a circular path along the edge of the sense layer. The vortex configuration provides a linear and non-hysteretic behavior in a large magnitude range of the external magnetic field. The vortex configuration is advantageous for magnetic sensor applications. A magnetoresistive sensor comprising the magnetoresistive sensor element with vortex configuration can have a small footprint and reduced current consumption. Such magnetoresistive sensor competes advantageously against semiconductor sensors based on the Hall effect.

The magnetoresistive sensor element can comprise an antiferromagnetic layer exchange coupling the reference layer such as to pin the reference magnetization. The strength and uniformity of the exchange coupling impacts the electrical response of the magnetoresistive sensor and its long-term stability.

A magnetoresistive sensor element is typically manufactured and magnetically programmed (to write the reference layer). To improve long-term stability, the programmed magnetoresistive sensor element is exposed to a high temperature heat treatment (bake) for conditioning and stabilizing magnetic and electrical properties of the magnetoresistive sensor element. The magnetoresistive sensor element can further be submitted to magnetic permeability testing that uses magnetic fields greater than 200 mT. During the heat treatment, the layers of the magnetoresistive sensor element relax towards a more stable magnetic state. However, relaxation of the antiferromagnetic layer during the heat treatment can lead to significant growth of full-cycle hysteresis which decreases the accuracy of the magnetoresistive sensor element.

The present inventors have shown that the heat treatment decreases the uniformity of the direction of the pinned reference magnetization of the reference layer. The pinned reference magnetization becomes distorted, and the distortion gets "frozen" after completion of the heat treatment, when the temperature of the magnetoresistive sensor element decreases. Typically, the distortion has a certain degree of chirality which makes the electrical resistance of the magnetoresistive sensor element to be sensitive to the (typically variable) vortex chirality in the sensing layer. The exposure to a high magnetic field (close to or above vortex expulsion field) acts on chirality switching which induce the different conductivity level. For example, the chirality switching (generated after high magnetic field exposure) without chiral distortion will induce two energetically equivalent states with similar conductivity levels, while the chirality switching with chiral distortion will generate different conductivity levels due to the nonsymmetrical magnetic distortion in the reference layer 21. Thus, the distortion may result in decreased accuracy, reproducibility, and repeatability in operation of the magnetoresistive sensor element.

Moreover, the magnetoresistive sensor element may have reduced usable measurement field range and a decrease in sensitivity. More generally, electrical offset shifts after high-field exposure (full-cycle hysteresis) are a serious problem observed with vortex-based magnetoresistive sensors, which limits their performance if they are exposed to high magnetic fields.

Prior solutions to reduce the distortion induced by heat treatment and high magnetic fields include modifying aspect ratio and materials of the sense layer in order to increase the expulsion field; modifying the shape of the magnetoresistive sensor element to block the chirality switching; and increasing the thermal stability of the antiferromagnetic layer exchange coupling the reference layer to decrease its degradation during the heat treatment.

European patent application EP20200315443 filed 2020 November 3 by the present inventors, discloses a magnetoresistive sensor element comprising a sense antiferromagnetic layer pinning a vortex sensing layer and a reference antiferromagnetic layer pinning a reference layer. The blocking temperature of the sense antiferromagnetic layer is smaller than the blocking temperature of the reference antiferromagnetic layer.

### Summary

The present disclosure concerns a magnetoresistive element comprising a reference layer having a fixed reference magnetization; a ferromagnetic sense layer having a free sense magnetization having a stable vortex configuration that is orientable relative to the fixed reference magnetization in the presence of an external magnetic field; and a tunnel barrier layer between the reference layer and the sense layer and contacting a first side of the sense layer. The magnetoresistive element further comprises a hard magnetic layer arranged on a second side of the sense layer opposed to the first side, the hard magnetic layer being configured to generate an interfacial magnetic coupling between the hard magnetic layer and the sense layer on the second side, such as to prevent chirality switching of the sense magnetization after the magnetoresistive element has been submitted to a heat treatment and an external magnetic field above vortex expulsion field.

The disclosed magnetoresistive element does not show hysteresis increase after being submitted to a high temperature heat treatment and/or to a high magnetic field (close to or above vortex expulsion field of the sense layer). The magnetoresistive element is thus robust to thermal degradation and to offset shifts after. In fact, the heat treatment can be performed at higher temperatures than the temperatures used with conventional magnetoresistive elements.

The magnetoresistive element can be manufactured using conventional manufacturing processes. Indeed, the disclosed magnetoresistive element does not require modifying the shape of the magnetoresistive element and the latter can have a conventional shape. In contrast to prior art solutions, the disclosed magnetoresistive element can use a broad range of antiferromagnetic and hard magnet materials to achieve the desired effects mentioned above. The antiferromagnetic layer can be grown in a conventional way.

### Short description of the drawings

Exemplar embodiments of the invention are disclosed in the description and illustrated by the drawings in which:
Fig. 1 illustrates a magnetoresistive element comprising a reference layer and a sense layer, according to an embodiment;
Figs. 2a and 2b illustrate a top view of the sense layer having a sense magnetization comprising a vortex configuration in absence (Fig. 2a) and in the presence (Fig. 2b) of an external magnetic field;
Fig. 3 illustrates the magnetoresistive element where the reference layer comprises a synthetic antiferromagnet structure;
Fig. 4 illustrates an exemplary magnetic sensor comprising a plurality of the magnetoresistive element, according to an embodiment.

### Examples of embodiments

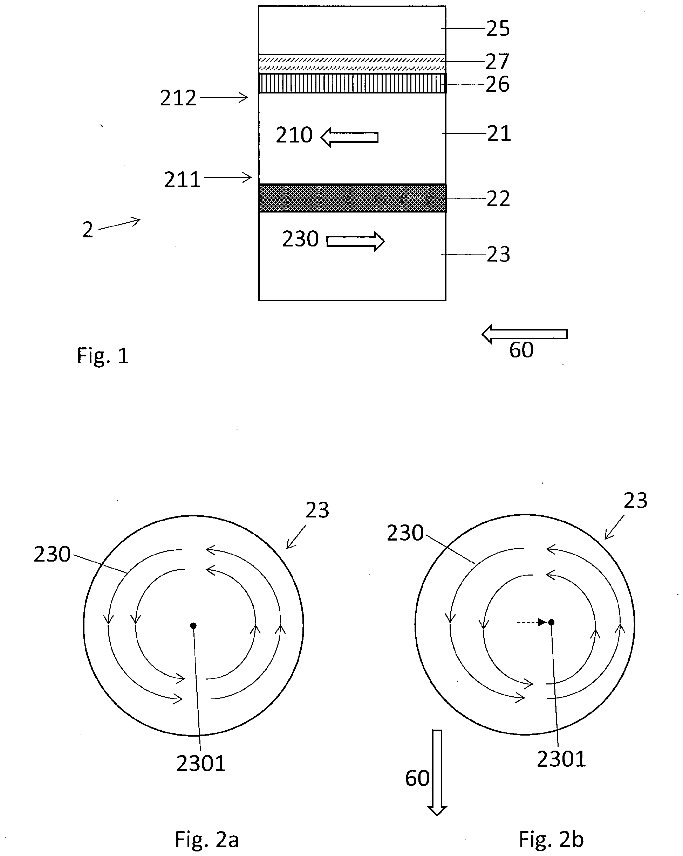

**Fig. 1** illustrates a magnetoresistive element 2 according to an embodiment. The magnetoresistive element 2 comprises a reference layer 23 having a pinned reference magnetization 230, a sense layer 21 having a free sense magnetization 210 that is orientable relative to the fixed reference magnetization 230 in the presence of an external magnetic field 60, and a tunnel barrier layer 22 between the sense and reference layers 21, 23. A first side 211 of the sense layer 21 contacts the tunnel barrier layer 22.

Each of the reference and sense layers 23, 21 can include, or be formed of, a magnetic material and, in particular, a magnetic material of the ferromagnetic type. The sense ferromagnetic layer 21 can include a soft ferromagnetic material, namely one having a relatively low coercivity, while the reference ferromagnetic layer 23 can include a hard ferromagnetic material, namely one having a relatively high coercivity. In such manner, a sense magnetization 210 of the sense ferromagnetic layer can be readily varied under low-intensity magnetic fields at which the reference magnetization 230 of the reference layer 23 remains fixed and is used as a reference layer. Suitable ferromagnetic materials include transition metals, rare earth elements, and their alloys, either with or without main group elements. For example, suitable ferromagnetic materials include iron ("Fe"), cobalt ("Co"), nickel ("Ni"), and their alloys, such as permalloy (or Ni80Fe20); alloys based on Ni, Fe, and boron ("B"); Co90Fe10; and alloys based on Co, Fe, and B. In some instances, alloys based on Ni and Fe (and optionally B) can have a smaller coercivity than alloys based on Co and Fe (and optionally B).

The sense layer 21 is in contact with the tunnel barrier layer 22. The sense layer 21 comprises a magnetically soft material and a free sense magnetization 210 that is orientable relative to the fixed reference magnetization 230 in the presence of an external magnetic field 60. The reference magnetization 230 remains substantially undisturbed. The sense magnetization 210 has a stable vortex configuration in the absence of an external magnetic field. The external magnetic field 60 can thus be sensed by measuring a resistance of the magnetoresistive element 2. The resistance depends on the orientation of the sense magnetization 210 relative to the reference magnetization 230.

In one aspect, the reference and sense layers 23, 21 comprise, or are formed of, a ferromagnetic material such as a cobalt ("Co"), iron ("Fe") or nickel ("Ni") based alloy and preferentially a CoFe, NiFe or CoFeB based alloy. The reference layer 23 can have a thickness between 2 nm and 7 nm. The reference and sense layers 23, 21 can comprise a ferromagnetic material such as a Co, Fe or Ni based alloy and preferentially a CoFe, NiFe or CoFeB based alloy, and non-magnetic material such as Ta, Ti, W, Ru, Ir. The ferromagnetic material(s) and the non-magnetic material(s) can be codeposited or/and multilayered.

The sense magnetization 230 comprises a stable vortex configuration rotating in a circular path along the edge of the sense layer 23 and around a core 2301, reversibly movable in accordance to the external magnetic field 60 (see Fig. 2a). Fig. 2a shows the sense magnetization 230 in absence of the external magnetic field 60 with the core 2301 of the vortex configuration being substantially at the center of the sense layer cross-section. In this configuration, the sense layer 23 has a net magnetic moment that is substantially zero (M=0). Fig. 2b shows the sense magnetization 230 in the presence of the external magnetic field 60. The external magnetic field 60 causes the core 2301 to move in a direction (shown by the doted arrow) substantially perpendicular to the one of the external magnetic field 60. The displacement of the core 2301 results in a net magnetic moment (M ≠ 0) in the sense layer 23.

In a desired configuration, the sense layer 21 has a thickness greater than 15 nm.

In a variant, the magnetoresistive element 2 can comprise a reference antiferromagnetic layer 24 disposed adjacent to the reference layer 23 and which, through exchange bias, pins the reference magnetization 230 along a particular direction when a temperature within, or in the vicinity of, the reference antiferromagnetic layer 24 is at a low threshold temperature TL, i.e., below a blocking temperature, such as a Neel temperature, or another threshold temperature of the reference antiferromagnetic layer 24. The reference antiferromagnetic layer 24 unpins, or frees, the reference magnetization 230 when the temperature is at the high threshold temperature TH, i.e., above the blocking temperature, thereby allowing the reference magnetization 230 to be switched to another direction. In this configuration, writing the reference layer 23 can comprise a step of heating the magnetoresistive element 2 at the high threshold temperature TH such as to unpin the reference magnetization 230 while providing a programming magnetic field. Once the reference magnetization 230 has been switched in the written direction, the magnetoresistive element 2 can be cooled down to the low threshold temperature TL, such as to pin the reference magnetization 230 in the written direction.

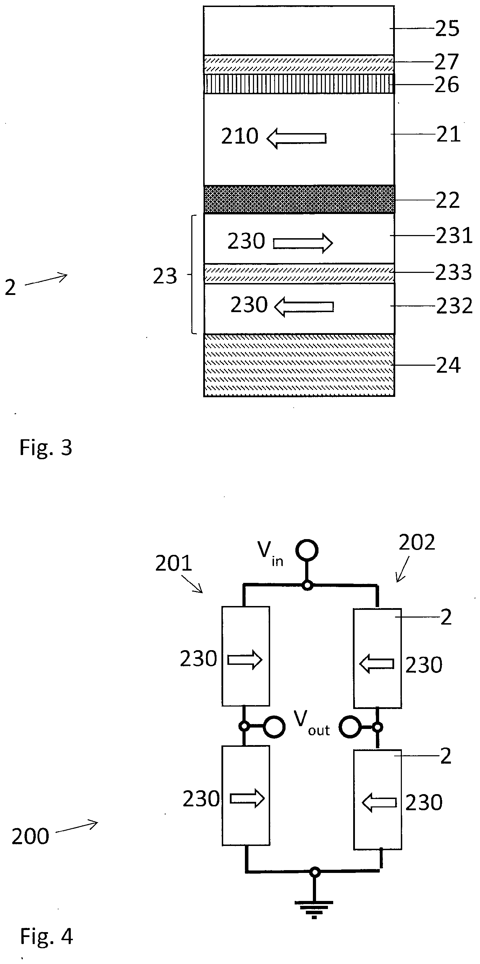

Other implementations of the sense layer 21 and the reference layer 23 are contemplated. For example, either, or both, of the sense layer 21 and the reference layer 23 can include multiple sub-layers in a fashion similar to that of the so-called synthetic antiferromagnetic layer. In the configuration shown in Fig. 3, the reference layer 23 comprises a synthetic antiferromagnet structure comprising at least a first ferromagnetic reference layer 231 and a second ferromagnetic reference layer 232 that are separated and coupled antiferromagnetically through an intervening non-magnetic layer 233. The non-magnetic layer is typically a Ru layer but can also comprise any of: Ru, Ir or Cu or a combination of these elements. In an antiferromagnet structure, the reference magnetization 230 of the first ferromagnetic layer 231 is coupled antiparallel to the reference magnetization 230 by the non-magnetic layer 233. In the case the magnetoresistive element 2 comprises a reference antiferromagnetic layer 24, the reference magnetization 230 of the second ferromagnetic layer 232 adjacent to the antiferromagnetic layer 24 is pinned by the antiferromagnetic layer 24.

The tunnel barrier layer 22 comprises, or is formed of, an insulating material. Suitable insulating materials include oxides, such as aluminum oxide (e.g., Al₂O₃) and magnesium oxide (e.g., MgO). A thickness of the tunnel barrier layer 22 can be in the nm range, such as from about 1 nm to about 10 nm. Large TMR for example of up to 200% can be obtained for the magnetic tunnel junction 2 comprising a crystalline MgO-based tunnel barrier layer 22.

When the magnetoresistive element 2 is submitted to a high temperature heat treatment (bake) and a high magnetic field, i.e., a magnetic field above vortex expulsion field, a substantially similar chiral distortion is generated in the sense layer 21 and in the reference layer 23. The chiral distortion favors a specific vortex chirality in the sensing vortex.

In an embodiment. the magnetoresistive element 2 further comprises a hard magnetic layer 25 arranged on a second side 212 of the sense layer 21, opposed to the first side 211. The hard magnetic layer 25 is configured to generate an interfacial magnetic coupling between the hard magnetic layer 25 and the sense layer 21 on the second side 212. The interfacial magnetic coupling can "freeze" (or pin) the sense magnetization 210 at least in the portion of the sense layer 21, such that chirality switching in the sense magnetization 210, due to the chiral distortion generated in the sense layer 21, is prevented.

According to simulations made by the inventors and to experimental data, the chiral distortion in the sense layer 21 is "frozen" (or pinned) by the hard magnetic layer 25 such that it substantially compensates the chiral distortion in the reference layer 23. In other words, the pinned chiral distortion in the sense layer 21 can cancel the negative effect of the pinned chiral distortion in the reference layer 23, and thus, significantly reduces the degree of hysteresis enhancement in the magnetoresistive element 2 after heat treatments. The magnetoresistive element 2 is thus robust to thermal degradation of offset shifts after high-field exposure.

In an embodiment, the hard magnetic layer 25 comprises a material having a high magnetic coercivity (for example greater than 500 A/m or 1000 A/m or 1500 A/m or 2000 A/m).

In one aspect, the high magnetic coercivity can be obtained with a material with exchange decoupled grains such as any one, alone or in combination of: CoCrPt, FePt-TiO₂, FePt-SiO₂, FePt-C, CoPt, NdFeB, or SmCo.

The high magnetic coercivity material can further comprise a perpendicular ferrimagnetic alloy including a rare earth, such as Tb, Gd, Sm, and a transition metal (such as Co, Fe, or CoFe).

The high magnetic coercivity material can further comprise a *L*1₀ perpendicular ordered alloy. Such alloy may include an alloy of CoPt or FePt type.

The high magnetic coercivity material can further comprise multilayers of 3d-4d metals, such as Co, Fe, CoFe, Ni, Pt, Pd, Au, or Ag, exhibiting perpendicular magnetic anisotropy.

The high magnetic coercivity material can further comprise a permanent magnet based on rare earths. For example, 1-5 or 2-17 type alloy (such as SmCo) or RE2Fe14B type alloy (where RE can be Nd, Dy, Pr, etc.).

The high magnetic coercivity material may comprise slightly decoupled grains. This can be achieved, for example, by inserting in the alloy a small amount of Cr, C, Cu, V, or an oxide.

In another embodiment, the hard magnetic layer 25 can comprise an antiferromagnetic material. The antiferromagnetic material can comprise any one, alone or in combination, of: IrMn, FeMn, PtMn, PdMn, CrPdMn, NiMn, CuMnAs, Mn₃Sn, Mn₂Au, Cr₂O, etc.

The blocking temperature, such as a Neel temperature, or another threshold temperature, of the antiferromagnetic material forming the hard magnetic layer 25 can be varied by varying the thickness of the antiferromagnetic containing hard magnetic layer 25.

In an aspect, the thickness of the hard magnetic layer 25 is between 2 nm and to 30 nm.

The magnetoresistive element 2 further comprises a mediating layer 26 between the hard magnetic layer 25 and the sense layer 21. The mediating layer 26 is configured to adjust the strength of the interfacial magnetic coupling between the hard magnetic layer 25 and the sense layer 21. The thickness of the mediating layer 26 can be configured such as to adjust the strength of the interfacial magnetic coupling to a value between -1 mJ/m² and +1 mJ/m².

In one aspect, the mediating layer 26 comprises a transition metal. The transition metal can include any one of: Ru, W, Ir, or Ta.

In a preferred configuration, the mediating layer 26 is not in contact with the hard magnetic layer 25.

In one aspect, the magnetoresistive element 2 can further comprise a ferromagnetic coupling layer 27 between the mediating layer 26 and the hard magnetic layer 25. In such configuration, the hard magnetic layer 25 is configured to generate an interfacial magnetic coupling between the hard magnetic layer 25 and the coupling layer 27 at the interface between the hard magnetic layer 25 and the coupling layer 27.

The strength of the interfacial magnetic coupling between the hard magnetic layer 25 and the sense layer 21 can be further adjusted by adjusting the thickness of the ferromagnetic coupling layer 27.

In an embodiment, a magnetic sensor comprises a plurality of the magnetoresistive element 2. The magnetoresistive elements 2 can be connected in parallel and or in series by nonmagnetic electrodes or conductors. The magnetoresistive elements 2 can be arranged such that the magnetic sensor forms a full-bridge or a half-bridge architecture.

**Fig. 4** illustrates an exemplary magnetic sensor 200 arranged in a bridge circuit. In one aspect, the bridge circuit may comprise at least a first branch 201 comprising two series-connected magnetoresistive elements 2 and a second branch 202 comprising two series-connected magnetoresistive elements 2. Each magnetoresistive element 2 in the first branch 201 can have its reference magnetization 230 programmed in a direction opposite to the reference magnetization 230 programmed direction of the magnetoresistive elements 2 in the second branch 202.

In one aspect, the lateral size of the magnetoresistive elements 2 is between 100 and 1000 nm.

The magnetoresistive elements 2 can have a circular, elliptical, or non-centrosymmetrical shape.

### Reference numbers and symbols

- 2: magnetoresistive element
- 21: sense layer
- 200: magnetic sensor
- 201: first branch
- 202: second branch
- 210: sense magnetization
- 211: first side of the sense layer
- 212: second side of the sense layer
- 22: tunnel barrier layer
- 23: reference layer
- 230: reference magnetization
- 231: first ferromagnetic reference layer
- 232: second ferromagnetic reference layer
- 233: non-magnetic layer
- 2301: core
- 24: reference antiferromagnetic layer
- 25: hard magnetic layer
- 26: mediating layer
- 27: coupling layer
- 60: external magnetic field

## Claims

1. Magnetoresistive element (2), comprising a reference layer (23) having a fixed reference magnetization (230); a ferromagnetic sense layer (21) having a free sense magnetization (210) having a stable vortex configuration that is orientable relative to the fixed reference magnetization (230) in the presence of an external magnetic field (60); and a tunnel barrier layer (22) between the reference layer (23) and the sense layer (21) and contacting a first side (211) of the sense layer (21); The magnetoresistive element (2) further comprises a hard magnetic layer (25) arranged on a second side (212) of the sense layer (21) opposed to the first side (211), the hard magnetic layer (25) being configured to generate an interfacial magnetic coupling between the hard magnetic layer (25) and the sense layer (21) on the second side (212), such as to prevent chirality switching of the sense magnetization (210) after the magnetoresistive element (2) has been submitted to a heat treatment and an external magnetic field above vortex expulsion field.

2. The magnetoresistive element according to claim 1, wherein the hard magnetic layer (25) comprises a material having a magnetic coercivity greater than 1000 A/m.

3. The magnetoresistive element according to claim 2, wherein the material comprises any one, alone or in combination, of: CoCrPt, FePt-TiO₂, FePt-SiO₂, FePt-C, CoPt, NdFeB, or SmCo.

4. The magnetoresistive element according to claim 2, wherein the high magnetic coercivity material comprises any one of: a perpendicular ferrimagnetic alloy comprising a rare earth and a transition metal; a perpendicular ordered alloy, multilayers of 3d-4d metals having perpendicular magnetic anisotropy, a permanent magnet based on one or a plurality of rare earth metals.

5. The magnetoresistive element according to claim 3 or 4,
wherein the high magnetic coercivity material further comprises Cr, C, Cu, V, or an oxide.

6. The magnetoresistive element according to claim 1,
wherein the hard magnetic layer (25) comprises an antiferromagnetic material.

7. The magnetoresistive element according to claim 6,
wherein the antiferromagnetic material comprises any one, alone or in combination, of: IrMn, FeMn, PtMn, PdMn, CrPdMn, NiMn, CuMnAs, Mn₃Sn, Mn₂Au, or C₂O.

8. The magnetoresistive element according to any one of claims 1 to 7
wherein the thickness of the hard magnetic layer (25) is between 2 nm and to 30 nm.

9. The magnetoresistive element according to any one of claims 1 to 8,
further comprising a mediating layer (26) between the sense layer portion (21) and the hard magnetic layer (25), the strength of the interfacial magnetic coupling being adjustable by adjusting the thickness of the mediating layer (26).

10. The magnetoresistive element according to claim 9,
wherein the mediating layer (26) comprises a transition metal, particularly Ru, W, Ir, or Ta.

11. The magnetoresistive element according to claim 9 or 10, wherein the thickness of the mediating layer (26) is configured such that the strength of the interfacial magnetic coupling has a value between -1 mJ/m² and +1 mJ/m².

12. The magnetoresistive element according to any one of claims 9 to 11,
further comprising a ferromagnetic coupling layer (27) between the mediating layer (26) and the hard magnetic layer (25);
the strength of the interfacial magnetic coupling being further adjustable by adjusting the thickness of the coupling layer (27).

13. The magnetoresistive element according to any one of claims 1 to 12,
wherein the magnetically soft material of the sense layer (21) comprises a combination of Ni, Fe, Co and transition metals.

14. The magnetoresistive element according to claim 13,
wherein the sense layer (21) has a thickness greater than 15 nm.

15. A magnetic sensor (200) comprising a plurality of the magnetoresistive element (2).
